# EUROPEAN PATENT SPECIFICATION

(11) **EP 3 629 084 B1**
(45) Date of publication and mention of the grant of the patent: **07.06.2023**
(21) Application number: 19197670.3
(22) Date of filing: 17.09.2019
(51) Int. Cl.: G03F 1/00, G03F 1/32, G03F 1/26

(54) **PHASE SHIFT-TYPE PHOTOMASK BLANK, METHOD OF PREPARING A PHOTOMASK AND PHASE SHIFT-TYPE PHOTOMASK**
ROHLING EINER PHASENVERSCHIEBUNGSPHOTOMASKE, VERFAHREN ZUR HERSTELLUNG EINER PHOTOMASKE UND PHASENVERSCHIEBUNGSPHOTOMASKE
ÉBAUCHE DE PHOTOMASQUE DE TYPE À DÉCALAGE DE PHASE, PROCÉDÉ DE FABRICATION D'UN PHOTOMASQUE ET PHOTOMASQUE DE TYPE À DÉCALAGE DE PHASE

(30) Priority: 26.09.2018 JP 2018180590
(43) Date of publication of application: 01.04.2020
(73) Proprietor: Shin-Etsu Chemical Co., Ltd., Tokyo (JP)
(72) Inventor: KOSAKA, Takuro, Joetsu-shi, Niigata (JP); OZAWA, Ryoken, Joetsu-shi, Niigata (JP)
(74) Representative: Mewburn Ellis LLP

(56) References cited:
- EP-A2- 3 079 012
- EP-A2- 3 136 171
- JP-A- 2018 063 441
- US-A1- 2002 122 991
- US-A1- 2002 136 963
- US-A1- 2018 335 692

## Description

### TECHNICAL FIELD

The invention relates to a phase shift-type photomask blank, a method for preparing a photomask and a phase shift-type photomask, typically used for manufacturing semiconductor integrated circuits.

### BACKGROUND

In the technical field of semiconductors, research and development for miniaturization of pattern is further in progress. Particularly, as integration of large-scale integrated circuit has advanced in recent years, there are accelerated trends towards miniaturization of circuit patterns, finer interconnect patterns, and miniaturization of the patterns of contact holes used for the interlayer connections that compose a cell, creating further demands for fine processing technology. Under such situation, there have been growing demands for development of a technology for forming finer and more precise circuit patterns (mask patterns), also in a technical field of manufacturing the photomasks used for the photolithographic process in fine processing.

Reduction projection is a most typical method for forming a pattern on a semiconductor substrate using photolithographic technology. For this purpose, the pattern size on the photomask is about four times larger than the pattern to be drawn on the semiconductor substrate. In the field of lithographic technology, the size of the circuit pattern to be drawn is considerably smaller than the wavelength of light used for exposure in present times. Hence, if a photomask pattern is simply formed as a four-times magnification of the circuit pattern, the original pattern of a photomask cannot be accurately transferred to a resist film on the semiconductor substrate because interference of light arising during exposure affects the transfer.

Thus, the pattern formed on the photomask is formed more intricately than the actual circuit pattern, to moderate such influence of interference of light in some cases. A pattern configuration for this purpose is exemplified by a configuration applied as an optical proximity correction (OPC) to the actual circuit pattern. For pattern miniaturization and accuracy enhancement, modified illumination, immersion lithography, and resolution enhancement technology (RET) are used, as well as double patterning lithography.

As one of the resolution enhancement technology (RET), a phase shift method is used. The phase shift method is a contrast enhancing method utilizing interference of light caused by a film pattern, capable of inverting phase approximately 180°, formed in the photomask. A halftone phase shift-type photomask is one of the photomask types employing such method. A halftone phase shift-type photomask includes a transparent substrate made of quartz or the like, which is transparent to the intended exposure light, and a mask pattern made of a halftone phase shift film formed thereon, which can invert the phase of such light approximately 180° and has a transmittance insufficient to contribute to pattern formation. An exemplary halftone phase shift-type photomask, repeatedly proposed, includes a halftone phase shift film composed of molybdenum silicon oxide (MoSiO), or molybdenum silicon oxynitride (MoSiON) (JP-A H07-140635 (Patent Document 1)).

### Citation List

Patent Document 1: JP-A H07-140635
Patent Document 2: JP-A 2007-33469
Patent Document 3: JP-A 2007-233179
Patent Document 4: JP-A-2007-241065

The Prior art document EP 3 079 012 A2 discloses a phase shift-type photomask blank according to the preamble of claim 1.

Documents US 2002/122991 A1 and US 2018/335692 A1 disclose high transmittance phase shift-type photomask blanks comprising a phase shift film composed of silicon, nitrogen and oxygen.

### THE INVENTION

The transmittance of a phase shift film has commonly been a transmittance of not more than 20%, typically about 6%, however, recent investigations are also directed to higher transmittances.

A film having a high transmittance has also a high attenuation effect of light due to interference, making it advantageous for fine patterning in some cases. To manufacture a phase shift-type photomask blank having a high transmittance, high oxygen content is needed for increasing the transmittance. However, while a higher oxygen content can increase the transmittance, the higher oxygen content can also cause a problem in that a refractive index of the film decreases so that a larger thickness of the film is needed to obtain a predetermined phase shift. Phase shift films are preferably thinner, not only because a thin film is advantageous for patterning, but also because a thin film can reduce three-dimensional effects. Hence, in photolithography, a thinner film is desired for forming finer patterns.

The invention was made in order to address the aforementioned problems. An aim herein is to provide a phase shift-type photomask blank and a phase shift-type photomask, having a thin phase shift film satisfying the requirement for pattern miniaturization, which is advantageous in terms of patterning and reduction of three-dimensional effects, while satisfying necessary phase shift and transmittance requirements for a phase shift film.

The inventors first investigated into commonly employed phase shift films that contain a transition metal such as molybdenum, in pursuit of development of a phase shift film that is thin but satisfies necessary phase shift and transmittance for the phase shift film. A phase shift film having a transmittance of at least 60% with respect to exposure light having a wavelength of 200 nm or less lowers in transmittance if even a small amount of transition metal is added. Addition of a larger amount of oxygen, intended to compensate for such a decline in transmittance, results in declined refractive index of the film at a desired transmittance as the amount of addition of oxygen increases. Thus, to provide the phase shift necessary for the phase shift film in this case, thickness of the film must be increased.

The inventors have found that, when a phase shift film consists of a single layer or multiple layers comprising one or more layers composed of transition metal, silicon, nitrogen and oxygen, and has a ratio of content of transition metal of at least 0.001 and not more than 0.03 expressed as atomic ratio of the transition metal to a total content of the transition metal and silicon, the phase shift film can be thinned to a thickness of 150 nm or less, even if the phase shift film is designed so as to have, with respect to an exposure light having a wavelength of up to 200 nm, a phase shift of 150 to 250° and a transmittance of 60 to 80%.

In one aspect, the invention provides a phase shift-type photomask blank comprising a substrate and a phase shift film thereon, the phase shift film consisting of a single layer or multiple layers, said single layer or multiple layers comprising one or more layers composed of transition metal, silicon, nitrogen and oxygen, provided that such layer composed of transition metal, silicon, nitrogen and oxygen has a transition metal content of up to at least 0.001 and not more than 0.03 expressed as atomic ratio of the transition metal to the total content of transition metal and silicon, wherein the phase shift film has a thickness up to 150 nm, and a phase shift of 150 to 250° and a transmittance of 60 to 80% with respect to light having a wavelength of not more than 200 nm.

Preferably, the layer composed of transition metal, silicon, nitrogen and oxygen has a content of at least 0.003 expressed as the atomic ratio of the transition metal to a total content of the transition metal and silicon.

Preferably, each layer composing the phase shift film, excluding any oxidized surface layer, has a total content of nitrogen and oxygen of at least 50 at%, and/or has a nitrogen content of at least 10 at%, and the nitrogen content is lower than an oxygen content in the layer.

Preferably, the transition metal comprises molybdenum.

Preferably, the phase shift-type photomask blank further comprises a second layer consisting of a single layer or multiple layers on the phase shift film, the second layer being composed of a chromium-containing material.

In another aspect, the invention provides a phase shift-type photomask prepared from the phase shift-type photomask blank, and a method of preparing such a photomask by patterning the phase shift film and preferably a said second layer of such a blank.

### ADVANTAGEOUS EFFECTS

According to the invention, we find that there can be provided a phase shift-type photomask blank and a phase shift-type photomask, having a thinner phase shift film which is advantageous in terms of patterning and exposure, while satisfying necessary phase shift and high transmittance for the phase shift film. The phase shift-type photomask are found to allow exposure satisfying requirements towards further miniaturization and higher preciseness of patterning in photolithography.

### BRIEF DESCRIPTION OF THE DRAWINGS

FIGS. 1A and 1B are cross-sectional views illustrating an exemplary types of phase shift-type photomask blank and phase shift-type photomask of the invention.
FIGS. 2A to 2C are cross-section views illustrating other example types of phase shift-type photomask blank of the invention.

### FURTHER EXPLANATIONS; OPTIONS AND PREFERENCES

The phase shift-type photomask blank of the invention includes a transparent substrate such as a quartz substrate, and a phase shift film that is provided on the transparent substrate, and consists of a single layer or of multiple layers (that is, at least two layers). The phase shift-type photomask of the invention includes a transparent substrate such as a quartz substrate, and a mask pattern (photomask pattern) of a phase shift film which is provided on the transparent substrate, and consists of a single layer or multiple layers (that is, at least two layers).

The transparent substrate in the invention is preferably, for example, a 6025 substrate. This is a well-known type, being 6 inch square, 25 milli-inch thick transparent substrate, as specified by the SEMI standard, which according to the SI unit system is often denoted as a 152 mm square, 6.35 mm thick transparent substrate.

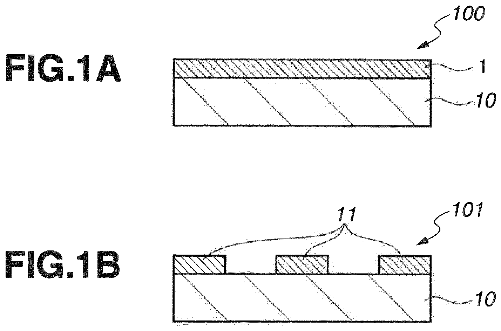

FIG. 1A is a cross-sectional view illustrating an exemplary phase shift-type photomask blank of the invention. In this embodiment, a phase shift-type photomask blank 100 includes a transparent substrate 10, and a phase shift film 1 formed on the transparent substrate 10. FIG. 1B is a cross-sectional view illustrating an exemplary phase shift-type photomask of the invention. In this embodiment, the phase shift-type photomask 101 includes the transparent substrate 10, and a phase shift film pattern 11 formed on the transparent substrate 10.

The phase shift film may consist of a single layer which is designed so as to satisfy necessary phase shift and transmittance characteristics for the phase shift film. The phase shift film alternatively consists of a plurality of layers selected so as to satisfy for the whole of the phase shift film the necessary phase shift and transmittance characteristics. Such plural layers might include, for example, a layer having antireflective function satisfying a desired surface reflectivity.

In both cases of single layer and multiple layers, each layer may be formed to have a composition continuously graded in the thickness direction. In case where the phase shift film is composed of a plurality of layers, such layers may be two or more layers selected from layers having different constituent elements, and/or layers having the same constituent elements but different compositional ratios. In a case where the multiple layers include at least three layers, layers of the same composition may be combined when these layers are not adjacent to each other.

The phase shift film in the invention consists of a single layer or multiple layers, such as one, two or three layers, and the single layer or multiple layers include at least one layer consisting of a layer composed of transition metal, silicon, nitrogen and oxygen. The layer composed of transition metal (Me), silicon (Si), nitrogen (N) and oxygen (O) is a layer substantially composed of these four elements only, except for inevitable impurities. Specifically, MeSiNO (transition metal silicon oxynitride) layer is exemplified. Note that MeSiNO merely denotes constituent elements, rather than compositional ratios of the constituent elements. Examples of the transition metal Me include molybdenum, zirconium, tungsten, titanium, hafnium, chromium and tantalum. In particular, the transition metal is preferably molybdenum.

The layer composed of transition metal, silicon, nitrogen and oxygen has a ratio of content (atomic ratio) of transition metal of at least 0.001 and not more than 0.03, preferably at least 0.001 and not more than 0.02, as the ratio of the transition metal to a total content of the transition metal and silicon. For plural such transition metal-containing layers, this may apply to each. The problem of dimensional change or degradation of pattern in the layer containing transition metal and silicon can be improved by the ratio of content of the transition metal to the total content of the transition metal and silicon, controlled within the aforementioned preferable range.

The phase shift film in the invention has a silicon content of preferably at least 30 at%, more preferably at least 35 at%, and preferably up to 45 at%, more preferably up to 40 at%, in a single layer as a whole when the phase shift film consists of such single layer; in one or more layers among a plurality of layers when the phase shift film consists of such plurality of layers; and particularly, in each layer of the plurality of layers excluding an oxidized surface layer described below when the phase shift film is provided with such oxidized surface layer.

The phase shift film in the invention has a nitrogen content of preferably at least 10 at%, more preferably at least 13 at%, and preferably up to 30 at%, more preferably up to 20 at%, or an oxygen content of preferably up to 60 at%, more preferably up to 50 at%, in a single layer as a whole when the phase shift film consists of such single layer; in one or more layers among a plurality of layers when the phase shift film consists of such plurality of layers; and particularly, in each layer of the plurality of layers excluding an oxidized surface layer described below when the phase shift film is provided with such oxidized surface layer.

The phase shift film in the invention has a total content of nitrogen and oxygen of preferably at least 50 at%, more preferably at least 60 at%, or preferably a nitrogen content lower than an oxygen content, in a single layer as a whole when the phase shift film consists of such single layer; in one or more layers among a plurality of layers when the phase shift film consists of such plurality of layers; and particularly, in each layer of the plurality of layers excluding an oxidized surface layer described below when the phase shift film is provided with such oxidized surface layer.

The phase shift film in the invention has a ratio of silicon and nitrogen (silicon/nitrogen) of preferably 3/1 to 4/1 (atomic ratio), in a single layer as a whole when the phase shift film consists of such single layer; in one or more layers among a plurality of layers when the phase shift film consists of such plurality of layers; and particularly, in each layer of the plurality of layers excluding an oxidized surface layer described below when the phase shift film is provided with such oxidized surface layer.

The phase shift film in the invention, with a prescribed thickness, has a predetermined phase shift amount (phase shift) and a predetermined transmittance, with respect to light (exposure light) having a wavelength of up to 200 nm, especially ArF excimer laser (193 nm) used for photolithography through a phase shift-type photomask.

The phase shift of the exposure light which passes through the phase shift film in the invention may be enough to be able to increase contrast at the boundary between an area having the phase shift film (phase shift area) and an area without the phase shift film, as a result of phase shift due to interference of exposure lights passing through the respective areas. The phase shift is at least 150°, preferably at least 170°, and up to 250°, preferably up to 230°. While most common phase shift films employ a phase shift of approximately 180°, the phase shift is not limited to approximately 180° according to the point of view for increasing the contrast. The phase shift film in the invention has the phase shift amount with respect to light (exposure light) having a wavelength of up to 200 nm, especially ArF excimer laser (193 nm), controlled within the aforementioned range. Meanwhile, a transmittance of the phase shift film in the invention is a a high transmittance of 60 to 80% with respect to the exposure light, which differs from the ordinary transmittance in prior art.

When a whole thickness of the phase shift film is thin, fine patterns can be readily formed. Thus, the whole thickness of the phase shift film in the invention is up to 150 nm, preferably up to 130 nm. Meanwhile, the lower limit of the thickness of the phase shift film may be set so long as the desired optical characteristics may be obtained with exposure light, and is typically at least 50 nm, however not limited thereto.

The phase shift film in the invention has a refractive index n of preferably at least 1.75, more preferably at least 1.8 with respect to exposure light, in a single layer as a whole when the phase shift film consists of such single layer; in one or more layers among a plurality of layers when the phase shift film consists of such plurality of layers; and particularly, in a plurality of layers as a whole excluding an oxidized surface layer described below when the phase shift film is provided with such oxidized surface layer. With an oxygen content of the phase shift film controlled to up to 60 at%, especially up to 50 at%, or with a reduced transition metal content (atomic ratio) of at least 0.001 as a ratio of the transition metal to the total content of transition metal and silicon, the phase shift film can have a prescribed transmittance and increased refractive index, and also can have a more reduced thickness, with satisfying a necessary phase shift for the phase shift film. When the oxygen content is low, the refractive index is high, and the high refractive index contributes to obtain a thinner film having a desired phase shift.

The phase shift film in the invention has an extinction coefficient k with respect to exposure light of more than 0 (zero), and preferably up to 0.1, more preferably up to 0.05, in a single layer as a whole when the phase shift film consists of such single layer; and in a plurality of layers as a whole when the phase shift film consists of such plurality of layers.

The phase shift film in the invention may be formed by known methods for forming film. The phase shift film is preferably formed by sputtering by which a highly homogenous film is easily obtainable, and the sputtering may be either DC sputtering or RF sputtering. Target and sputtering gas are properly selected depending on kind and composition of the layer to be formed. Examples of the target include silicon targets, silicon nitride targets, and targets containing both of silicon and silicon nitride. These targets may contain oxygen. The targets may contain the transition metal. A target containing a transition metal and a target free of a transition metal may be used at the same time. The nitrogen content and the oxygen content may be controlled by reactive sputtering using any of reactive gases such as a nitrogen-containing gas, an oxygen-containing gas, and a nitrogen and oxygen-containing gas under properly controlling an amount of feeding. In particular, nitrogen gas (N₂ gas), oxygen gas (O₂ gas), and nitrogen oxide gases (N₂O gas, NO gas and NO₂ gas) may be used for the reactive gas. Also rare gases such as helium gas, neon gas and argon gas are employable as the sputtering gas.

The phase shift film consisting multiple layers may include an oxidized surface layer formed as the outermost layer on the top face (on the side remote from the transparent substrate), for the purpose of suppressing change of properties of the phase shift film. The oxidized surface layer may have an oxygen content of at least 20 at%, preferably at least 50 at%. Examples of methods for forming the oxidized surface layer specifically include atmospheric oxidation (natural oxidation); and forced oxidation treatment such as treatment of a sputtered film with ozone gas or ozonated water, or heating at least 300°C in an oxygen-containing atmosphere such as oxygen gas atmosphere, by heating in oven, lamp annealing or laser heating. The oxidized surface layer preferably has a thickness of up to 10 nm, more preferably up to 5nm, most preferably up to 3 nm. An effect of the oxidized surface layer is obtainable typically with a thickness of at least 1 nm. While the oxidized surface layer may be formed by sputtering under an increased oxygen amount, the oxidized surface layer is more preferably formed by the aforementioned atmospheric oxidation or oxidation treatment in terms of obtaining the layer with fewer defects.

The phase shift-type photomask blank of the invention may include a second layer consisting of a single layer or multiple layers, and is formed over the phase shift film. The second layer is usually provided adjacent to the phase shift film. The second layer is specifically exemplified by a light shielding film, a combination of a light shielding film and an antireflection film, and a process-aid film that functions as a hard mask in the process of patterning the phase shift film. In case where a third layer is employed as described below, the second layer may be used as a process-aid film that functions as an etching stopper (etching stopper film) in the process of patterning the third layer. Material of the second layer is preferably a chromium-containing material.

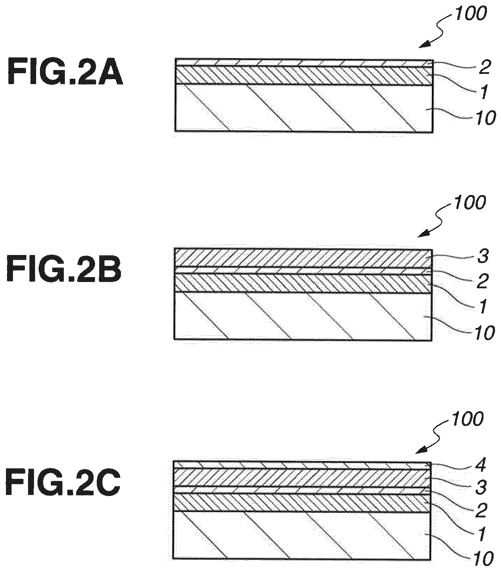

This embodiment is specifically exemplified by a phase shift-type photomask blank illustrated in FIG. 2A. FIG. 2A is a cross-sectional view illustrating an exemplary phase shift-type photomask blank of the invention. In this embodiment, a phase shift-type photomask blank 100 includes a transparent substrate 10, a phase shift film 1 formed on the transparent substrate 10, and a second layer 2 formed on the phase shift film 1.

The phase shift-type photomask blank of the invention may include a light shielding film as the second layer, provided over the phase shift film. Alternatively, a light shielding film and an antireflection film may be combined to form the second layer. The second layer including a light shielding film can provide an area that is fully block the exposure light in a phase shift-type photomask. The light shielding film and the antireflection film may also be used as a process-aid film in the etching. There are many reports regarding film structure and materials for the light shielding film and antireflection film (JP-A 2007-33469 (Patent Document 2), JP-A 2007-233179 (Patent Document 3), for example). Preferred film structures having a light shielding film and an antireflection film combined therein are exemplified by a structure in which a light shielding film composed of a chromium-containing material is provided, and an antireflection film composed of a chromium-containing material for reducing reflection from the light shielding film is further provided. The light shielding film and the antireflection film may consist of a single layer or multiple layers. Examples of the chromium-containing material of the light shielding film and the antireflection film include chromium (simple substance), and a chromium compound such as chromium oxide (CrO), chromium nitride (CrN), chromium carbide (CrC), chromium oxynitride (CrON), chromium oxycarbide (CrOC), chromium nitride carbide (CrNC) and chromium oxynitride carbide (CrONC). Notebly, the chemical formulae that represent the chromium-containing materials merely denote constituent elements, rather than compositional ratios of the constituent elements (the same shall apply to the chromium-containing materials hereinafter).

For the second layer as the light shielding film, or the combination of a light shielding film and an antireflection film, the chromium compound in the light shielding film has a chromium content of preferably at least 40 at%, more preferably at least 60 at%, and preferably less than 100 at%, more preferably up to 99 at%, most preferably up to 90 at%. The oxygen content is preferably up to 60 at%, more preferably up to 40 at%, and preferably at least 1 at%. The nitrogen content is preferably up to 50 at%, more preferably up to 40 at%, and preferably at least 1 at%. The carbon content is preferably up to 20 at%, more preferably up to 10 at%, and if the etching rate is necessarily adjusted, preferably at least 1 at%. In this case, a total content of chromium, oxygen, nitrogen and carbon is preferably at least 95 at%, more preferably at least 99 at%, and most preferably 100 at%.

For the second layer as the combination of a light shielding film and an antireflection film, the antireflection film is preferably composed of a chromium compound, and the chromium compound has a chromium content of preferably at least 30 at%, more preferably at least 35 at%, and up to 70 at%, more preferably up to 50 at%. The oxygen content is preferably up to 60 at%, and preferably at least 1 at%, more preferably at least 20 at%. The nitrogen content is preferably up to 50 at%, more preferably up to 30 at%, and preferably at least 1 at%, more preferably at least 3 at%. The carbon content is preferably up to 20 at%, more preferably up to 5 at%, and if the etching rate is necessarily adjusted, preferably at least 1 at%. In this case, a total content of chromium, oxygen, nitrogen and carbon is preferably at least 95 at%, more preferably at least 99 at%, most preferably 100 at%.

For the second layer as the light shielding film, or the combination of a light shielding film and an antireflection film, the second layer has a thickness of usually 20 to 100 nm, and preferably 40 to 70 nm. A total optical density of the phase shift film and the second layer are preferably at least 2.0, more preferably at least 2.5, most preferably at least 3.0, with respect to exposure light having a wavelength of up to 200 nm.

Over the second layer of the phase shift-type photomask blank of the invention, a third layer consisting of a single layer or multiple layers may be provided. The third layer is usually provided adjacent to the second layer. The third layer is specifically exemplified by a process-aid film that functions as a hard mask in the process of patterning the second layer, a light shielding film, and a combination of a light shielding film and an antireflection film. A material composing the third layer is preferably a silicon-containing material, particularly a silicon-containing material free of chromium.

This embodiment is specifically exemplified by a phase shift-type photomask blank illustrated in FIG. 2B. FIG. 2B is a cross-sectional view illustrating an exemplary phase shift-type photomask blank of the invention. In this embodiment, the phase shift-type photomask blank 100 includes a transparent substrate 10, a phase shift film 1 formed on the transparent substrate 10, a second layer 2 formed on the phase shift film 1, and a third layer 3 formed on the second layer 2.

For the second layer as the light shielding film, or the combination of a light shielding film and an antireflection film, a process-aid film (etching mask film) which functions as a hard mask in the process of patterning the second layer may be provided as the third layer. In case where a fourth layer is employed as described below, the third layer may be used as a process-aid film that functions as an etching stopper (etching stopper film) in the process of patterning the fourth layer. The process-aid film is preferably composed of a material that differs in etching characteristics from the second layer, such as a material resistant to chlorine-based dry etching for a chromium-containing material, in particular, a silicon-containing material which can be etched by fluorine-containing gases such as SF₆ and CF₄. Examples of the silicon-containing material include silicon (simple substance), and a silicon compound such as a material containing silicon, and either or both of nitrogen and oxygen, a material containing silicon and a transition metal, and a material containing silicon, and either or both of nitrogen and oxygen with a transition metal. Examples of the transition metal include molybdenum, tantalum and zirconium.

For the third layer as the process-aid film, the process-aid film is preferably composed of a silicon compound. The silicon compound has a silicon content of preferably at least 20 at%, more preferably at least 33 at%, and preferably up to 95 at%, and more preferably up to 80 at%. The nitrogen content is preferably up to 50 at%, more preferably up to 30 at%, and preferably at least 1 at%. The oxygen content is preferably up to 70 at%, more preferably up to 66 at%, and if the etching rate is necessarily adjusted, preferably at least 1 at%, more preferably at least 20 at%. The transition metal content is preferably up to 35 at%, more preferably up to 20 at%. In this case, a total content of silicon, oxygen, nitrogen and transition metal is preferably at least 95 at%, more preferably at least 99 at%, most preferably 100 at%.

For the second layer as the light shielding film, or the combination of a light shielding film and an antireflection film, and for the third layer as the process-aid film, the second layer has a thickness of usually 20 to 100 nm, and preferably 40 to 70 nm, and the third layer typically has a thickness of usually 1 to 30 nm, and preferably 2 to 15 nm. A total optical density of the phase shift film and the second layer are preferably at least 2.0, more preferably at least 2.5, most preferably at least 3.0, with respect to exposure light having a wavelength of up to 200 nm.

For the second layer as the process-aid film, a light shielding film may be provided as the third layer. The light shielding film in combination with the antireflection film may be provided as the third layer. In this case, the second layer may be used as a process-aid film (etching mask film) that functions as a hard mask in the process of patterning the phase shift film, and as a process-aid film (etching stopper film) in the process of patterning the third layer. The process-aid film is exemplified by a film composed of a chromium-containing material, such as disclosed in JP-A 2007-241065 (Patent Document 4). The process-aid film may consist of a single layer or multiple layers. Examples of the chromium-containing material of the process-aid film include chromium (simple substance), and a chromium compound such as chromium oxide (CrO), chromium nitride (CrN), chromium carbide (CrC), chromium oxynitride (CrON), chromium oxycarbide (CrOC), chromium nitride carbide (CrNC) and chromium oxynitride carbide (CrONC).

For the second layer as the process-aid film, the chromium compound in the second layer has a chromium content of preferably at least 40 at%, more preferably at least 50 at%, and preferably up to 100 at%, more preferably up to 99 at%, most preferably up to 90 at%. The oxygen content is preferably up to 60 at%, more preferably up to 55 at%, and if the etching rate is necessarily adjusted, preferably at least 1 at%. The nitrogen content is preferably up to 50 at%, more preferably up to 40 at%, and preferably at least 1 at%. The carbon content is preferably up to 20 at%, more preferably up to 10 at%, and if the etching rate is necessarily adjusted, preferably at least 1 at%. In this case, a total content of chromium, oxygen, nitrogen and carbon is preferably at least 95 at%, particularly at least 99 at%, most preferably 100 at%.

The light shielding film and the antireflection film as the third layer are preferably composed of a material that differs in etching characteristics from the second layer, such as a material resistant to chlorine-based dry etching for a chromium-containing material, in particular, a silicon-containing material which can be etched by fluorine-containing gases such as SF₆ and CF₄. Examples of the silicon-containing material include silicon (simple substance), and a silicon compound such as a material containing silicon, and either or both of nitrogen and oxygen, a material containing silicon and a transition metal, and a material containing silicon, and either or both of nitrogen and oxygen with a transition metal. Examples of the transition metal include molybdenum, tantalum and zirconium.

For the third layer as the light shielding film, or the combination of a light shielding film and an antireflection film, the light shielding film and the antireflection film are preferably composed of a silicon compound. The silicon compound has a silicon content of preferably at least 10 at%, more preferably at least 30 at%, and preferably less than 100 at%, more preferably up to 95 at%. The nitrogen content is preferably up to 50 at%, preferably up to 40 at%, and most preferably up to 20 at%, and if the etching rate is necessarily adjusted, preferably at least 1 at%. The oxygen content is preferably up to 60 at%, more preferably up to 30 at%, and if the etching rate is necessarily adjusted, preferably at least 1 at%. The transition metal content is preferably up to 35 at%, preferably up to 20 at%, and preferably at least 1 at%. In this case, a total content of silicon, oxygen, nitrogen and transition metal is preferably at least 95 at%, more preferably at least 99 at%, most preferably 100 at%.

For the second layer as the process-aid film, and for the third layer as the light shielding film, or the combination of a light shielding film and an antireflection film, the second layer has a thickness of usually 1 to 20 nm, and preferably 2 to 10 nm, and the third layer has a thickness of usually 20 to 100 nm, and preferably 30 to 70 nm. A total optical density of the phase shift film, the second layer and the third layer are preferably at least 2.0, more preferably at least 2.5, most preferably at least 3.0, with respect to exposure light having a wavelength of up to 200 nm.

Over the third layer of the phase shift-type photomask blank of the invention, a fourth layer consisting of a single layer or multiple layers may be provided. The fourth layer is usually provided adjacent to the third layer. The fourth layer is specifically exemplified by a process-aid film that functions as a hard mask in the process of patterning the third layer. A material of the fourth layer is preferably a chromium-containing material.

This embodiment is specifically exemplified by a phase shift-type photomask blank illustrated in FIG. 2C. FIG. 2C is a cross-sectional view illustrating an exemplary phase shift-type photomask blank of the invention. In this embodiment, the phase shift-type photomask blank 100 includes a transparent substrate 10, a phase shift film 1 formed on the transparent substrate 10, a second layer 2 formed on the phase shift film 1, a third layer 3 formed on the second layer 2, and a fourth layer 4 formed on the third layer 3.

For the third layer as the light shielding film, or the combination of a light shielding film and an antireflection film, a process-aid film (etching mask film) which functions as a hard mask in the process of patterning the third layer may be provided as the fourth layer. The process-aid film is preferably composed of a material that differs in etching characteristics from the third layer, such as a material resistant to fluorine-based dry etching for a silicon-containing material, in particular, a chromium-containing material which can be etched by chlorine-based gases containing oxygen. The chromium-containing material is exemplified by chromium (simple substance), and a chromium compound such as chromium oxide (CrO), chromium nitride (CrN), chromium carbide (CrC), chromium oxynitride (CrON), chromium oxycarbide (CrOC), chromium nitride carbide (CrNC) and chromium oxynitride carbide (CrONC).

For the fourth layer as the process-aid film, the fourth layer has a chromium content of preferably at least 40 at%, more preferably at least 50 at%, and preferably up to 100 at%, more preferably up to 99 at%, most preferably up to 90 at%. The oxygen content is preferably up to 60 at%, more preferably up to 40 at%, and if the etching rate is necessarily adjusted, preferably at least 1 at%. The nitrogen content is preferably up to 50 at%, more preferably up to 40 at%, and if the etching rate is necessarily adjusted, preferably at least 1 at%. The carbon content is preferably up to 20 at%, more preferably up to 10 at%, and if the etching rate is necessarily adjusted, preferably at least 1 at%. In this case, a total content of chromium, oxygen, nitrogen and carbon is preferably at least 95 at%, more preferably at least 99 at%, most preferably 100 at%.

For the second layer as the process-aid film, for the third layer as the light shielding film, or the combination of a light shielding film and an antireflection film, and for the fourth layer as the process-aid film, the second layer has a thickness of usually 1 to 20 nm, and preferably 2 to 10 nm, the third layer has a thickness of usually 20 to 100 nm, and preferably 30 to 70 nm, and the fourth layer has a thickness of usually 1 to 30 nm, and preferably 2 to 20 nm. A total optical density of the phase shift film, the second layer and the third layer are preferably at least 2.0, more preferably at least 2.5, most preferably at least 3.0, with respect to exposure light having a wavelength of up to 200 nm.

The film composed of the chromium-containing material for the second layer and the fourth layer may be formed by reactive sputtering using a target such as a chromium target, or a target containing chromium to which is added one or more elements selected from the group consisting of oxygen, nitrogen and carbon, and using a sputtering gas containing a rare gas such as Ar, He and Ne that is properly added with a reactive gas selected from the group consisting of an oxygen-containing gas, a nitrogen-containing gas and a carbon-containing gas, according to a composition of the film to be formed.

Meanwhile, the film composed of the silicon-containing material for the third layer may be formed by reactive sputtering using a target such as a silicon target, a silicon nitride target, a target containing both of silicon and silicon nitride, a transition metal target, and a composite target of silicon and transition metal, and using a sputtering gas containing a rare gas such as Ar, He and Ne that is properly added with a reactive gas selected from the group consisting of an oxygen-containing gas, a nitrogen-containing gas and a carbon-containing gas, according to a composition of the film to be formed.

The phase shift-type photomask of the invention may be manufactured by any of usual methods used for phase shift-type photomask blanks. Considering an exemplary phase shift-type photomask blank including a film composed of a chromium-containing material formed as a second layer on a phase shift film, the phase shift-type photomask may be manufactured typically by the following processes.

First, an electron beam resist film is formed on the second layer of the phase shift-type photomask blank, a pattern is drawn by electron beam, followed by a predetermined operation of development, to obtain a resist pattern. Next, the obtained resist pattern is used as an etching mask, and the resist pattern is transferred to the second layer by chlorine-based dry etching containing oxygen, to obtain a second layer pattern. Next, the obtained second layer pattern is used as an etching mask, and the second layer pattern is transferred to the phase shift film by fluorine-based dry etching, to obtain a phase shift film pattern.

In case where a part of the second layer is needed to be remained, another resist pattern that protects such part to be remained is formed on the second layer, and a part of the second layer not protected with the resist pattern is removed by chlorine-based dry etching containing oxygen. The resist pattern is then removed by a usual method to obtain the phase shift-type photomask.

From an exemplary phase shift-type photomask blank including a light shielding film or a combination of a light shielding film and an antireflection film, composed of a chromium-containing material, as a second layer on a phase shift film, and a process-aid film composed of a silicon-containing material as a third layer on the second layer, the phase shift-type photomask may be manufactured typically by the following processes.

First, an electron beam resist film is formed on the third layer of the phase shift-type photomask blank, a pattern is drawn by electron beam, followed by a predetermined operation of development, to obtain a resist pattern. Next, the obtained resist pattern is used as an etching mask, and the resist pattern is transferred to the third layer by fluorine-based dry etching, to obtain a third layer pattern. Next, the obtained third layer pattern is used as an etching mask, and the third layer pattern is transferred to the second layer by chlorine-based dry etching containing oxygen, to obtain a second layer pattern. The resist pattern is then removed, and the obtained second layer pattern is used as an etching mask, and the second layer pattern is transferred to the phase shift film by fluorine-based dry etching, to obtain a phase shift film pattern and to concurrently remove the third layer pattern. Next, another resist pattern that protects a part of the second layer to be remained is formed on the second layer, and a part of the second layer not protected with the resist pattern is removed by chlorine-based dry etching containing oxygen. The resist pattern is then removed by a usual method to obtain the phase shift-type photomask.

Meanwhile, from an exemplary phase shift-type photomask blank including a process-aid film composed of a chromium-containing material as a second layer on a phase shift film, and a light shielding film or a combination of a light shielding film and an antireflection film, composed of a silicon-containing material, as a third layer on the second layer, the phase shift-type photomask may be manufactured typically by the following processes.

First, an electron beam resist film is formed on the third layer of the phase shift-type photomask blank, a pattern is drawn by electron beam, followed by a predetermined operation of development, to obtain a resist pattern. Next, the obtained resist pattern is used as an etching mask, and the resist pattern is transferred to the third layer by fluorine-based dry etching, to obtain a third layer pattern. Next, the obtained third layer pattern is used as an etching mask, and the third layer pattern is transferred to the second layer by chlorine-based dry etching containing oxygen, to obtain a second layer pattern that a part where the phase shift film will be removed has been removed. The resist pattern is then removed. Next, another resist pattern that protects a part of the third layer to be remained is formed on the third layer, and the obtained second layer pattern is used as an etching mask, and the second layer pattern is transferred to the phase shift film by fluorine-based dry etching, to obtain a phase shift film pattern, and to concurrently remove a part of the third layer which is not protected with the resist pattern. The resist pattern is then removed by a usual method. Further, the part of the second layer, which is exposed in the part where the third layer has been removed, is then removed by chlorine-based dry etching containing oxygen, to obtain the phase shift-type photomask.

Further, from an exemplary phase shift-type photomask blank including a process-aid film composed of a chromium-containing material as a second layer on a phase shift film, a light shielding film or a combination of a light shielding film and an antireflection film, composed of a silicon-containing material, as a third layer on the second layer, and a process-aid film composed of a chromium-containing material, as a fourth layer on the third layer, the phase shift-type photomask may be manufactured typically by the following processes.

First, an electron beam resist film is formed on the fourth layer of the phase shift-type photomask blank, a pattern is drawn by electron beam, followed by a predetermined operation of development, to obtain a resist pattern. Next, the obtained resist pattern is used as an etching mask, and the resist pattern is transferred to the fourth layer by chlorine-based dry etching containing oxygen, to obtain a fourth layer pattern. Next, the obtained fourth layer pattern is used as an etching mask, and the fourth layer pattern is transferred to the third layer by fluorine-based dry etching, to obtain a third layer pattern. The resist pattern is then removed. Next, another resist pattern that protects a part of the third layer to be remained is formed on the fourth layer, and the obtained third layer pattern is used as an etching mask, and the third layer pattern is transferred to the second layer by chlorine-based dry etching containing oxygen, to obtain a second layer pattern, and to concurrently remove a part of the fourth layer which is not protected with the resist pattern. Next, the second layer pattern is used as an etching mask, and the second layer pattern is transferred to the phase shift film by fluorine-based dry etching, to obtain a phase shift film pattern, and to concurrently remove a part of the third layer which is not protected with the resist pattern. The resist pattern is then removed by a usual method. Further, the part of the second layer, which is exposed in the part where the third layer has been removed, and the part of the fourth layer exposed in the part where the resist pattern has been removed, are then removed by chlorine-based dry etching containing oxygen, to obtain the phase shift-type photomask.

The phase shift-type photomask of the invention is particularly effective in photolithography for forming a pattern with a half pitch of up to 50 nm, particularly up to 30 nm, especially up to 20 nm on a substrate to be processed, when a mask pattern is transferred to a photoresist film formed on the substrate to be processed by using exposure light having a wavelength of up to 200 nm such as ArF excimer laser (193 nm) and F₂ laser (157 nm).

A method of pattern exposure employs the phase shift-type photomask manufactured from the phase shift-type photomask blank, through which a photomask pattern that includes a phase shift film pattern is irradiated with exposure light, to thereby transfer the photomask pattern to a photoresist film which is formed on a substrate to be processed and is an object of exposure through to the photomask pattern. The exposure light may be irradiated by dry exposure or immersion exposure. The method of pattern exposure is particularly effective when the method is applied to exposure through a photomask pattern by immersion exposure, which tends to be increased cumulative irradiation energy within a relatively short time in practical production, and especially by immersion exposure that is applied to a wafer having a size of at least 300 mm, as a substrate to be processed.

### EXAMPLES

Examples of the invention are given below by way of illustration and not by way of limitation.

### Comparative Example 1

A 152 mm square, 6.35 mm thick 6025 quartz substrate was placed in a chamber of a sputtering apparatus, and a single-layer phase shift film made of SiON was formed thereon by using a silicon (Si) target as a sputtering target, and argon gas, nitrogen gas and oxygen gas as sputtering gas, under the following conditions: power applied to the silicon (Si) target 1,000 W, flow rate of argon gas 15 sccm, flow rate of nitrogen gas 11 sccm, and flow rate of oxygen gas 11 sccm, to thereby obtain a phase shift-type photomask blank. The phase shift film had a phase shift of 188° and a transmittance of 71%, with respect to ArF excimer laser (193nm), and a thickness of 113 nm. The film had a composition of 38 at% of silicon (Si), 16 at% of nitrogen (N), and 46 at% of oxygen (O), analyzed by XPS (X-ray photoelectron spectroscopy, the same shall apply hereinafter).

### Example 1

A 152 mm square, 6.35 mm thick 6025 quartz substrate was placed in a chamber of a sputtering apparatus, and a single-layer phase shift film made of MoSiON (merely denoting constituent elements, rather than compositional ratios of the constituent elements, the same shall apply hereinafter) was formed thereon by using a molybdenum silicide (MoSi, merely denoting constituent elements, rather than compositional ratios of the constituent elements, the same shall apply hereinafter) target and a silicon (Si) target as sputtering targets, and argon gas, nitrogen gas and oxygen gas as sputtering gas, under the following conditions: power to be applied to the molybdenum silicide (MoSi) target 50 W, power to be applied to the silicon (Si) target 1,800 W, flow rate of argon gas 15 sccm, flow rate of nitrogen gas 20 sccm, and flow rate of oxygen gas 13.5 sccm, to thereby obtain a phase shift-type photomask blank. The phase shift film had a phase shift of 185° and a transmittance of 75%, with respect to ArF excimer laser (193nm), and a thickness of 112 nm. The film had a composition of 37 at% of silicon (Si), 15 at% of nitrogen (N), and 47 at% of oxygen (O), and a ratio of content (atomic ratio) of molybdenum (Mo) to the total content of molybdenum (Mo) and silicon (Si) of 0.002, analyzed by XPS, and thereby had a molybdenum (Mo) content of less than 1 at%. Whereas the phase shift film of this Example was designed to contain a minute amount of transition metal (Mo), the phase shift film had phase shift, transmittance and thickness, all comparable to those of the phase shift film free of transition metal (Mo) obtained in Comparative Example 1.

### Example 2

A 152 mm square, 6.35 mm thick 6025 quartz substrate was placed in a chamber of a sputtering apparatus, and a single-layer phase shift film made of MoSiON was formed thereon by using a molybdenum silicide (MoSi) target and a silicon (Si) target as sputtering targets, and argon gas, nitrogen gas and oxygen gas as sputtering gas, under the following conditions: power to be applied to the molybdenum silicide (MoSi) target 100 W (which was higher than in Example 2), power to be applied to the silicon (Si) target 1,750 W, flow rate of argon gas 15 sccm, flow rate of nitrogen gas 20 sccm, and flow rate of oxygen gas 16 sccm, to thereby obtain a phase shift-type photomask blank. The phase shift film had a phase shift of 190° and a transmittance of 74%, with respect to ArF excimer laser (193nm), and a thickness of 130 nm. The film had a composition of 36 at% of silicon (Si), 10 at% of nitrogen (N), and 53 at% of oxygen (O), and a ratio of content (atomic ratio) of molybdenum (Mo) to the total content of molybdenum (Mo) and silicon (Si) of 0.02, analyzed by XPS, and thereby had a molybdenum (Mo) content of less than 1 at%.

### Comparative Example 2

A 152 mm square, 6.35 mm thick 6025 quartz substrate was placed in a chamber of a sputtering apparatus, and a single-layer phase shift film made of MoSiON was formed thereon by using a molybdenum silicide (MoSi) target and a silicon (Si) target as sputtering targets, and argon gas, nitrogen gas and oxygen gas as sputtering gas, under the following conditions: power to be applied to the molybdenum silicide (MoSi) target 150 W (which was higher than in Example 3), power to be applied to the silicon (Si) target 1,700 W, flow rate of argon gas 17 sccm, flow rate of nitrogen gas 20 sccm, and flow rate of oxygen gas 18.7 sccm, to thereby obtain a phase shift-type photomask blank. The phase shift film had a phase shift of 195° and a transmittance of 71%, with respect to ArF excimer laser (193nm), and a thickness of 152 nm. The film had a composition of 34 at% of silicon (Si), 5 at% of nitrogen (N), and 60 at% of oxygen (O), and a ratio of content (atomic ratio) of molybdenum (Mo) to the total content of molybdenum (Mo) and silicon (Si) of 0.03, analyzed by XPS, and thereby had a molybdenum (Mo) content of 1 at%.

### Comparative Example 3

A 152 mm square, 6.35 mm thick 6025 quartz substrate was placed in a chamber of a sputtering apparatus, and a single-layer phase shift film made of MoSiON was formed thereon by using a molybdenum silicide (MoSi) target and a silicon (Si) target as sputtering targets, and argon gas, nitrogen gas and oxygen gas as sputtering gas, under the following conditions: power to be applied to the molybdenum silicide (MoSi) target 200 W (which was higher than in Comparative Example 1), power to be applied to the silicon (Si) target 1,650 W, flow rate of argon gas 15 sccm, flow rate of nitrogen gas 23.5 sccm, and flow rate of oxygen gas 20 sccm, to thereby obtain a phase shift-type photomask blank. The phase shift film had a phase shift of 188° and a transmittance of 73%, with respect to ArF excimer laser (193nm), and a thickness of 160 nm. The film had a composition of 32 at% of silicon (Si), 2.6 at% of nitrogen (N), and 64 at% of oxygen (O), and a ratio of content (atomic ratio) of molybdenum (Mo) to the total content of molybdenum (Mo) and silicon (Si) of 0.04, analyzed by XPS, and thereby had a molybdenum (Mo) content of 1 at%.

### Comparative Example 4

A 152 mm square, 6.35 mm thick 6025 quartz substrate was placed in a chamber of a sputtering apparatus, and a single-layer phase shift film made of SiO was formed thereon by using a silicon (Si) target as a sputtering target, and argon gas and oxygen gas as sputtering gas, under the following conditions: power to be applied to the silicon (Si) target 1,000 W, flow rate of argon gas 15 sccm, and flow rate of oxygen gas 40 sccm, to thereby obtain a phase shift-type photomask blank. The phase shift film had a phase shift of 215° and a transmittance of 90%, with respect to ArF excimer laser (193nm), and a thickness of 200 nm. The film had a composition of 33 at% of silicon (Si), and 67 at% of oxygen (O), analyzed by XPS.

## Claims

1. A phase shift-type photomask blank comprising a substrate (10) and a phase shift film (1) thereon, the phase shift film consisting of a single layer or multiple layers, said single layer or multiple layers comprising
one or more layers composed of transition metal, silicon, nitrogen and oxygen, provided that such layer composed of transition metal, silicon, nitrogen and oxygen has a transition metal content of at least 0.001 and not more than 0.03 expressed as atomic ratio of the transition metal to the total content of transition metal and silicon, wherein the phase shift film (1) has a thickness up to 150 nm, and a phase shift of 150 to 250° with respect to light having a wavelength of not more than 200 nm,
**characterized in that**
the phase shift film (1) has a transmittance of 60 to 80% with respect to light having the wavelength of not more than 200 nm.

2. Phase shift-type photomask blank of claim 1, wherein
the layer composed of transition metal, silicon, nitrogen and oxygen has a said transition metal content of at least 0.003 expressed as the atomic ratio of the transition metal to a total content of the transition metal and silicon.

3. Phase shift-type photomask blank of claim 1, wherein the phase shift film (1) has a thickness of 130 nm or less.

4. Phase shift-type photomask blank of any one of claims 1 to 3 wherein the or each layer composing the phase shift film (1), excluding any oxidized surface layer, has a total content of nitrogen and oxygen of at least 50 at%.

5. Phase shift-type photomask blank of claim 4 wherein the or each layer composing the phase shift film (1) has a total content of nitrogen and oxygen of at least 60 at%.

6. Phase shift-type photomask blank of any one of the preceding claims wherein the or each layer composing the phase shift film (1), excluding any oxidized surface layer, has a nitrogen content of at least 10 at%, and the nitrogen content is lower than an oxygen content in said layer.

7. Phase shift-type photomask blank of any one of the preceding claims wherein the phase shift film has a silicon content of from 30 at% to 45 at%, either in a single layer as a whole when the phase shift film consists of a single layer, or in each layer of the plurality of layers when the phase shift film consists of such plurality of layers, but excluding any oxidized surface layer.

8. Phase shift-type photomask blank of any one of the preceding claims wherein the phase shift film (1) comprises a said layer composed of transition metal, silicon, nitrogen and oxygen, and the transition metal comprises molybdenum.

9. Phase shift-type photomask blank of any one of the preceding claims comprising a second layer (2) consisting of a single layer or multiple layers on the phase shift film (1), the second layer being composed of a chromium-containing material.

10. Phase shift-type photomask blank of any one of the preceding claims wherein the phase shift film (1) has said phase shift and transmittance characteristics with respect to light which is ArF excimer laser of wavelength 193 nm or F₂ laser of wavelength 157 nm.

11. A method of preparing a photomask, comprising patterning the phase shift film of a blank as defined in any one of claims 1 to 10.

12. A phase shift-type photomask prepared from a phase shift-type photomask blank of any one of claims 1 to 10.

## Patentansprüche

1. Fotomaskenrohling vom Phasenverschiebungstyp, der ein Substrat (10) und einen Phasenverschiebungsfilm (1) darauf umfasst, wobei der Phasenverschiebungsfilm aus einer Einzelschicht oder mehreren Schichten besteht, wobei die Einzelschicht oder die mehreren Schichten Folgendes umfasst:
eine oder mehrere Schichten, die aus einem Übergangsmetall, Silicium, Stickstoff und Sauerstoff bestehen, mit der Maßgabe, dass eine solche Schicht, die aus einem Übergangsmetall, Silicium, Stickstoff und Sauerstoff besteht, einen Übergangsmetallgehalt von zumindest 0,001 und nicht mehr als 0,03 aufweist, der als Atomverhältnis des Übergangsmetalls zu dem Gesamtgehalt von Übergangsmetall und Silicium ausgedrückt wird, wobei der Phasenverschiebungsfilm (1) eine Dicke von bis zu 150 nm und eine Phasenverschiebung von 150 bis 250° in Bezug auf Licht mit einer Wellenlänge von nicht mehr als 200 nm aufweist, **dadurch gekennzeichnet, dass** der Phasenverschiebungsfilm (1) einen Transmissionsgrad von 60 bis 80 % in Bezug auf Licht mit der Wellenlänge von nicht mehr als 200 nm aufweist.

2. Fotomaskenrohling vom Phasenverschiebungstyp nach Anspruch 1, wobei die Schicht, die aus einem Übergangsmetall, Silicium, Stickstoff und Sauerstoff besteht, einen Übergangsmetallgehalt von zumindest 0,003 aufweist, der als Atomverhältnis von Übergangsmetall zu Gesamtgehalt von Übergangsmetall und Silicium ausgedrückt wird.

3. Fotomaskenrohling vom Phasenverschiebungstyp nach Anspruch 1, wobei der Phasenverschiebungsfilm (1) eine Dicke von 130 nm oder weniger aufweist.

4. Fotomaskenrohling vom Phasenverschiebungstyp nach einem der Ansprüche 1 bis 3, wobei die oder jede Schicht, aus der/denen der Phasenverschiebungsfilm (1) besteht, mit Ausnahme einer oxidierten Oberflächenschicht, einen Gesamtgehalt von Stickstoff und Sauerstoff von zumindest 50 Atom-% aufweist.

5. Fotomaskenrohling vom Phasenverschiebungstyp nach Anspruch 4, wobei die oder jede Schicht, aus der/denen der Phasenverschiebungsfilm (1) besteht, einen Gesamtgehalt von Stickstoff und Sauerstoff von zumindest 60 Atom-% aufweist.

6. Fotomaskenrohling vom Phasenverschiebungstyp nach einem der vorangegangenen Ansprüche, wobei die oder jede Schicht, aus der/denen der Phasenverschiebungsfilm (1) besteht, mit Ausnahme einer oxidierten Oberflächenschicht, einen Stickstoffgehalt von zumindest 10 Atom-% aufweist und der Stickstoffgehalt niedriger als ein Sauerstoffgehalt in der Schicht ist.

7. Fotomaskenrohling vom Phasenverschiebungstyp nach einem der vorangegangenen Ansprüche, wobei der Phasenverschiebungsfilm einen Siliciumgehalt von 30 Atom-% bis 45 Atom-% aufweist, entweder in einer Einzelschicht als Ganzes, wenn der Phasenverschiebungsfilm aus einer Einzelschicht besteht, oder in jeder Schicht aus der Vielzahl von Schichten, wenn der Phasenverschiebungsfilm aus einer solchen Vielzahl von Schichten besteht, wobei jegliche oxidierte Oberflächenschicht ausgenommen ist.

8. Fotomaskenrohling vom Phasenverschiebungstyp nach einem der vorangegangenen Ansprüche, wobei der Phasenverschiebungsfilm (1) eine Schicht umfasst, die aus einem Übergangsmetall, Silicium, Stickstoff und Sauerstoff besteht, und das Übergangsmetall Molybdän umfasst.

9. Fotomaskenrohling vom Phasenverschiebungstyp nach einem der vorangegangenen Ansprüche, der eine zweite Schicht (2) umfasst, die aus einer Einzelschicht oder mehreren Schichten auf dem Phasenverschiebungsfilm (1) besteht, wobei die zweite Schicht aus einem chromhältigen Material besteht.

10. Fotomaskenrohling vom Phasenverschiebungstyp nach einem der vorangegangenen Ansprüche, wobei der Phasenverschiebungsfilm (1) die Phasenverschiebung und Transmissionsgradeigenschaften in Bezug auf Licht aufweist, das ein ArF-Excimerlaser mit einer Wellenlänge von 193 nm oder ein F₂-Laser mit einer Wellenlänge von 157 nm ist.

11. Verfahren zur Herstellung einer Fotomaske, das das Strukturieren des Phasenverschiebungsfilms eines Rohlings nach einem der Ansprüche 1 bis 10 umfasst.

12. Fotomaske vom Phasenverschiebungstyp, die aus einem Fotomaskenrohling vom Phasenverschiebungstyp nach einem der Ansprüche 1 bis 10 hergestellt wird.

## Revendications

1. Ébauche de photomasque de type à décalage de phase comprenant un substrat (10) et un film à décalage de phase (1) sur celui-ci, le film à décalage de phase étant constitué d'une couche unique ou de couches multiples, ladite couche unique ou lesdites couches multiples comprenant
une ou plusieurs couches composées d'un métal de transition, de silicium, d'azote et d'oxygène, à condition qu'une telle couche composée d'un métal de transition, de silicium, d'azote et d'oxygène présente une teneur en métal de transition d'au moins 0,001 et d'au plus 0,03 exprimée en rapport atomique du métal de transition par rapport à la teneur totale en métal de transition et en silicium, dans laquelle le film à décalage de phase (1) présente une épaisseur allant jusqu'à 150 nm, et un décalage de phase de 150 à 250° par rapport à la lumière présentant une longueur d'onde de pas plus de 200 nm,
**caractérisée en ce que**
le film à décalage de phase (1) présente une transmittance de 60 à 80 % par rapport à de la lumière présentant une longueur d'onde ne dépassant pas 200 nm.

2. Ébauche de photomasque de type à décalage de phase selon la revendication 1, dans laquelle
la couche composée de métal de transition, de silicium, d'azote et d'oxygène présente une teneur en métal de transition d'au moins 0,003 exprimée en rapport atomique du métal de transition à une teneur totale du métal de transition et du silicium.

3. Ébauche de photomasque de type à décalage de phase selon la revendication 1, dans laquelle le film à décalage de phase (1) présente une épaisseur de 130 nm ou moins.

4. Ébauche de photomasque de type à décalage de phase selon l'une quelconque des revendications 1 à 3, dans laquelle la couche ou chaque couche composant le film à décalage de phase (1), à l'exclusion de toute couche superficielle oxydée, présente une teneur totale en azote et en oxygène d'au moins 50 % en atome.

5. Ébauche de photomasque de type à décalage de phase selon la revendication 4, dans laquelle la couche ou chaque couche composant le film à décalage de phase (1) présente une teneur totale en azote et en oxygène d'au moins 60 % en atome.

6. Ébauche de photomasque de type à décalage de phase selon l'une quelconque des revendications précédentes, dans laquelle la couche ou chaque couche composant le film à décalage de phase (1), à l'exclusion de toute couche de surface oxydée, présente une teneur en azote d'au moins 10 % en atome, et la teneur en azote est inférieure à une teneur en oxygène dans ladite couche.

7. Ébauche de photomasque de type à décalage de phase selon l'une quelconque des revendications précédentes, dans laquelle le film à décalage de phase présente une teneur en silicium comprise de 30 % en atome à 45 % en atome, soit dans une couche unique dans son ensemble lorsque le film à décalage de phase consiste en une couche unique, soit dans chaque couche de la pluralité de couches lorsque le film à décalage de phase consiste en une telle pluralité de couches, mais à l'exclusion de toute couche de surface oxydée.

8. Ébauche de photomasque de type à décalage de phase selon l'une quelconque des revendications précédentes, dans laquelle le film à décalage de phase (1) comprend ladite couche composée de métal de transition, de silicium, d'azote et d'oxygène, et le métal de transition comprend du molybdène.

9. Ébauche de photomasque du type à décalage de phase selon l'une quelconque des revendications précédentes, comprenant une seconde couche (2) constituée d'une couche unique ou de couches multiples sur le film à décalage de phase (1), la seconde couche étant composée d'un matériau contenant du chrome.

10. Ébauche de photomasque de type à décalage de phase selon l'une quelconque des revendications précédentes, dans laquelle le film à décalage de phase (1) présente lesdites caractéristiques de décalage de phase et de transmittance par rapport à une lumière qui est un laser excimer ArF de longueur d'onde de 193 nm ou un laser F₂ de longueur d'onde de 157 nm.

11. Procédé de préparation d'un photomasque, comprenant la formation d'un motif sur le film à décalage d'une ébauche selon l'une quelconque des revendications 1 à 10.

12. Photomasque de type à décalage de phase préparé à partir d'une ébauche de masque à décalage de phase selon l'une quelconque des revendications 1 à 10.
